# FASCICULE DE BREVET EUROPEEN

(11) **EP 0 514 250 B1**
(45) Date de publication et mention de la délivrance du brevet: **15.01.1997**
(21) Numéro de dépôt: 92401285.9
(22) Date de dépôt: 12.05.1992
(51) Int. Cl.: G01R 1/067, G01R 31/302

(54) **Dispositif pour tests hyperfréquences à large bande réalisés in situ**
Einrichtung für in situ Ultrahochfrequenztests mit grosser Bandbreite
Device for in situ ultra high frequency broadband testing

(30) Priorité: 14.05.1991 FR 9105804
(43) Date de publication de la demande: 19.11.1992
(73) Titulaire: THOMSON-CSF, 75008 Paris (FR)
(72) Inventeur: Cachier, Gérard, F-92045 Paris la Défense (FR)
(74) Mandataire: Albert, Claude

(56) Documents cités:
- EP-A- 0 299 432
- EP-A- 0 367 542
- EP-A- 0 392 830
- EP-A- 0 419 725
- WO-A-90/13039
- US-A- 4 795 989
- 1989 IEEE MTT-S INTERNATIONAL MICROWAVE SYMPOSIUM DIGEST vol. 1, Juin 1989, LONG BEACH, CAL. , US pages 823 - 825; S.S.OSOFSKY ET AL.: 'A Non-Contacting Probe for Measurements on High-Frequency Planar Circuits'
- IEEE TRANSACTIONS ON MICROWAVE THEORY AND TECHNIQUES vol. 34, no. 4, Avril 1986, pages 463 - 467; S.E.SCHWARZ ET AL.: 'Measurement Techniques for Planar High-Frequency Circuits'

## Description

L'invention concerne un dispositif permettant de faire des tests hyperfréquences réalisés in situ, c'est-à-dire en des points arbitraires d'un circuit hybride ou monolithique fonctionnant dans la gamme des hyperfréquences.

Les circuits hybrides ou monolithiques permettent de réaliser des fonctions hyperfréquences complexes qui nécessitent d'être testées à différents niveaux. Cette nécessité provient de la nature intrinsèquement analogique de ces circuits, laquelle entraîne automatiquement des gabarits de réalisation resserrés. Ce besoin est particulièrement critique en hyperfréquences car les longueurs d'onde considérées entraînent un accroissement correspondant de la sensibilité des circuits aux dimensions.

Par ailleurs, les performances demandées aux fonctions hyperfréquences (puissance, facteur de bruit, linéarité, bande passante et caractéristiques de filtrage, précision des modulations, ...) conditionnent directement celles de l'équipement intégrateur et doivent par conséquent être garanties de façon la plus précise possible. Le caractère précurseur de beaucoup de composants hyperfréquences, utilisés parfois en limites de performances, accentue le besoin de tests hyperfréquences.

Jusqu'à présent, on a l'habitude de tester avant montage les composants actifs (diodes, transistors, circuits intégrés) en les faisant travailler en continu, en fonction d'un gabarit donné, et ce dans les phases maquette, prototype et série. Les circuits intégrés peuvent aussi être testés en hyperfréquences grâce à des machines de test sous pointes comme celles vendues par CASCADE MICROWAVE.

Suivant les cas, ces composants actifs sont montés en boîtier, sur un support pour puce testable ("chip carrier"), ou directement en puces dans la fonction hyperfréquences.

Dans les deux premiers cas, un test hyperfréquence est réalisé afin de contrôler les performances finales des composants et parce qu'il est plus facile de comprendre l'origine d'un défaut éventuel et de le réparer.

Les fonctions hyperfréquences sont réalisées dans des boîtiers protecteurs étanches ou hermétiques, munis de connecteurs. Un test est parfois effectué avant la fermeture du boîtier pour des réglages finaux et éventuellement des réparations. Ceci s'applique en particulier aux boîtiers complexes ou de performances critiques.

Finalement, le boîtier est fermé, et testé afin de contrôler les performances du sous-ensemble, de l'ensemble, et de l'équipement intégrateur. Il s'agit là de tests dits d'intégration.

Les tests dits in situ sont ceux que l'on pratique en chaque emplacement de la fonction hyperfréquence. D'un point de vue général, les tests in situ sont utiles car il existe un lien direct entre la topologie d'un circuit semi- conducteur et les fonctions électriques réalisées par celui-ci. Plus précisément, on distingue trois niveaux de besoins pour des tests in situ :
- en études ou maquettes, certains couplages entre circuits ou certaines distributions de l'énergie dans les lignes d'alimentation des circuits sont encore mal modélisées, et un outil de mesure de ces énergies permettrait de lever certaines incertitudes de conception ;
- en prototypes, certaines performances ne sont atteintes qu'après réglage. Pour effectuer ces tests, on réalise des boîtiers séparés, que l'on règle et que l'on assemble ensuite. Toutefois cette procédure est coûteuse et de plus ne permet pas de miniatutriser correctement les fonctions hyperfréquences. Un test hyperfréquence in situ permettrait, par exemple, l'adaptation d'amplificateurs montés en cascade sur une céramique, en mesurant la tension existant en un ou plusieurs points des circuits interétages. Un test hyperfréquence in situ permettrait aussi la réalisation de mesures de taux d'ondes stationnaires (TOS) de sortie d'amplificateurs de puissance sans banc de test spécifique ;
- en série, les tests hyperfréquences habituels et les tests sur les alimentations ne permettent pas de localiser les défauts de construction, comme un câblage hyperfréquence défectueux ou même un câblage continu défectueux puisque plusieurs composants sont généralement alimentés en parallèle.

Une solution connue à ces problèmes a été décrite par S.S. Osofsky et al dans l'article "A Non-Contacting Probe for Measurements on High-Frequency Planar Circuits" 1989 IEEE MTT-S International Microwave Symposium Digest, vol. 1, Juin 1989, Long Beach, Cal., US; pages 823-825. Cette solution consiste à prévoir une sonde sans contact du champ magnétique existant au-dessus d'une ligne hyperfréquence à microruban ou coplanaire. Cette sonde composée de deux boucles de courant et une ligne hyperfréquence de sortie est gravée sur une plaquette de silicium. Cependant, pour assurer un couplage correct par prélèvement avec une ligne hyperfréquence du circuit à tester sans avoir d'effet notable sur ce dernier, il faut assurer un positionnement extrêmement précis de la sonde et de son support au-dessus de la ligne (à quelques dizaines de micromètres) ce qui est difficile à réaliser et coûteux. De plus, on doit réaliser la gravure de la sonde et de sa ligne de sortie sur une surface à pans coupés, ce qui augmente les difficultés de réalisation.

L'objet de l'invention est de pallier les inconvénients précités de l'état de la technique.

En particulier un objectif de l'invention est de proposer un dispositif qui permet de résoudre les problèmes de tests des circuits hybrides fonctionnant dans la gamme des hyperfréquences.

Un autre objectif de l'invention est de proposer un dispositif, pour tests hyperfréquences à large bande réalisés in situ, qui soit d'une manipulation facile pour être positionné en différents endroits d'une fonction hyperfréquence et qui s'adapte aux équipements de mesures sous pointes actuels (continus ou hyperfréquences).

Essentiellement, le principe de l'invention consiste en un composant de type "puce" destiné à être posé sur le substrat d'un circuit hybride à tester pour capter l'onde électromagnétique rayonnée au-dessus du substrat par le circuit hybride et fournir cette onde ou un signal de mesure des caractéristiques de cette onde à une machine de test sous pointes. L'invention s'applique donc de préférence aux structures ouvertes telles que lignes microruban, lignes coplanaires ou autre.

Plus spécifiquement, l'invention a pour objet un dispositif pour tests hyperfréquences à large bande réalisés in situ tel que défini dans les revendications.

D'autres caractéristiques et avantages de l'invention apparaîtront encore mieux à la lecture de la description ci-dessous faite en référence aux dessins dans lesquels :
- la figure 1 illustre le principe du dispositif pour tests hyperfréquences selon l'invention ;
- la figure 2 représente une vue de dessus du dispositif pour tests hyperfréquences selon un premier mode de réalisation de l'invention ;
- la figure 3 représente une vue de dessus du dispositif pour tests hyperfréquences selon un second mode de réalisation de l'invention ;
- la figure 4 représente une vue de dessus du dispositif pour tests hyperfréquences selon un troisième mode de réalisation de l'invention.

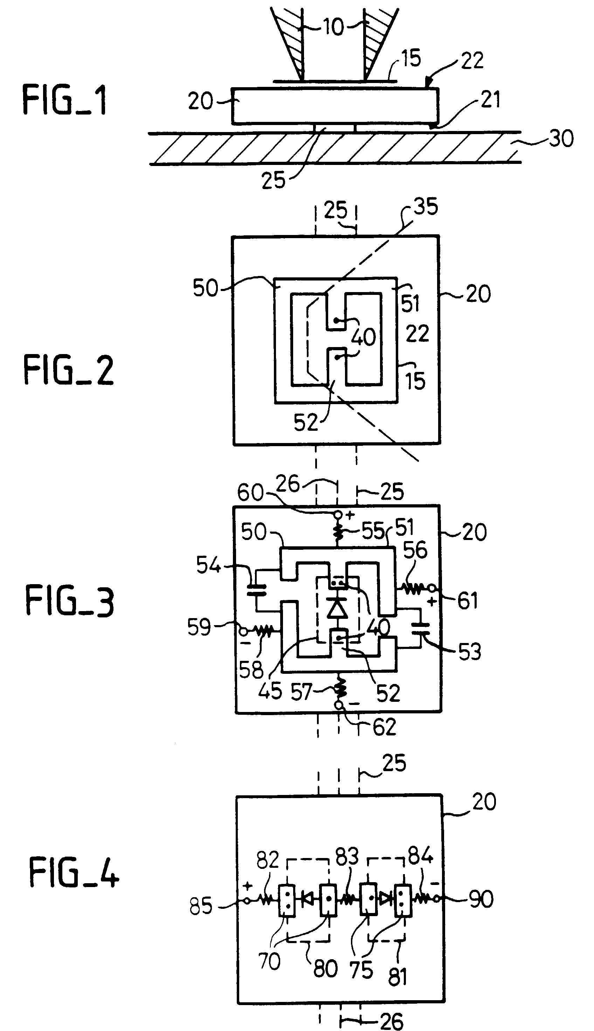

Sur la figure 1, le dispositif pour tests hyperfréquences large bande réalisés in situ comprend un support tel que 20, constitué d'une lamelle de silice, et des moyens de couplage hyperfréquences tels que 15 portés par le moyen support pour venir au dessus d'une ligne hyperfréquence 25 (par exemple une ligne microruban) d'un circuit hyperfréquence et jouer le rôle d'une antenne de réception.

Sur cette figure on a représenté le substrat 30 du circuit hyperfréquence à tester in situ. En fonctionnement hyperfréquence, la ligne hyperfréquence rayonne une onde électromagnétique au dessus du substrat. Le principe selon l'invention consiste à capter un champ électromagnétique engendré par l'onde électromagnétique afin de mesurer ces caractéristiques. La mesure est réalisée par un dispositif de tests ayant des pointes de test (continu ou hyperfréquence) telles que 10 venant se poser sur des points de tests (plots de contact) des moyens de couplage hyperfréquence.

Le couplage hyperfréquence peut être un couplage direct, un couplage au champ magnétique ou un couplage au champ électrique de l'onde électromagnétique ou tout autre couplage permettant de prélever les caractéristiques de l'onde électromagnétique rayonnée. A cet effet, on utilise soit des sondes dipolaires de tension, soit des sondes à boucles de courant comme décrit ci-après. On pourrait tout aussi bien utiliser les effets électrooptiques de l'AsGa ou les effets thermiques des cristaux liquides en combinaison avec des détecteurs de lumière ou de gradient de température.

Une fois que le signal hyperfréquence est prélevé par les moyens de couplage 15, il est :
- remonté sur une ligne hyperfréquence, une fibre optique ou autre, jusqu'à un équipement de mesure,
- ou converti en un signal électrique in situ, ce signal électrique étant ensuite fourni à l'équipement de mesure.

Le choix entre ces différentes possibilités s'effectue en fonction :
- du type de substrat (alumine, AsGa),
- du nombre de points de mesure simultanés,
- de la fréquence de travail du circuit à tester,
- de la largeur de bande nécessaire,
- de la dynamique de la mesure,
- de la nécessité de connaître la phase du signal hyperfréquence,
- de la compatibilité avec les équipements de mesure,
- des contraintes apportées au circuit.

La lamelle de silice 20 a la forme d'un carré d'environ 1mm de côté et une épaisseur d'environ 0,1mm. La lamelle peut donc être positionnée à l'aide d'un microscope binoculaire sur le dessus d'une ligne hyperfréquence d'un circuit hybride même complexe et ce, en différents points de mesure de la fonction hyperfréquence. La lamelle de silice a une face inférieure 21, directement en vis-à-vis avec la ligne microruban 25, qui est nue et transparente et une face supérieure 22 métallisée. La face supérieure métallisée est gravée pour former des plots de connexion, des sondes à boucles de courant ou des sondes dipolaires de tension. Ces sondes sont utilisées par des pointes d'une machine de test sous pointes conventionnelle. La lamelle de silice a l'avantage de positionner correctement la ou les sondes en hauteur par rapport à la ligne hyperfréquence 25. De préférence, l'épaisseur de la lamelle de silice, responsable du coefficient de couplage avec la ligne hyperfréquence, doit avoir une valeur suffisante pour permettre un couplage par prélèvement compris entre -20dB et -50dB.

Selon un premier mode de réalisation de l'invention, illustré sur la figure 2, la surface supérieure 22 métallisée de la lamelle de silice 20 est gravée pour former une sonde 15 à boucles de courant 50,51 ayant deux plots de contacts 40.

Le signal de courant hyperfréquence capté par la sonde à boucles de courant est envoyé dans des pointes hyperfréquence d'une céramique 35 (dite "céramique Cascade"), ces pointes étant placées sur les plots de contact 40.

Cette solution toute hyperfréquence permet d'exploiter l'amplitude et la phase du signal de courant hyperfréquence développé dans la sonde à boucles de courant.

Selon un second mode de réalisatlon de l'invention, illustré sur la figure 3, la surface supérieure 22 métallisée de la lamelle de silice 20 est aussi gravée pour former une sonde à boucles de courant 50,51 qui permet de réaliser un couplage au champ magnétique de l'onde hyperfréquence.

Les deux boucles de courant 50, 51, disposées symétriquement par rapport à l'axe longitudinal 26 de la ligne hyperfréquence, fonctionnent en tête-bêche et ont une partie de boucle commune 52 coupée pour former deux bornes de connexion 40. Les deux bornes de connexion 40 sensiblement alignées sur l'axe longitudinal 26, sont reliées entre elles par une diode Schottky telle que 45 montée en appui sur trois points sur le dessus de la gravure métallique. La diode 45 permet de détecter in situ un signal de courant hyperfréquence redressé représentatif du champ magnétique de l'onde hyperfréquence au point de test considéré.

Les deux boucles de courant 50,51 sont en outre munies de capacités 54,53 d'environ 1pF chacune pour ne pas court-circuiter la diode 45. La sonde de courant représentée sur cette figure possède deux options de sorties sous pointes, respectivement 59,61 et 60,62 à travers des résistances de protection respectivement 56,58 et 55,57, destinées à alimenter des pointes (continu) d'une machine de test.

Selon un troisième mode de réalisation de l'invention, illustré sur la figure 4, la surface supérieure 22 métallisée de la lamelle de silice 20 est gravée pour former une sonde dipolaire de tension pour réaliser un couplage au champ électrique de l'onde hyperfréquence. La sonde dipolaire de tension comprend deux dipôles 70, 75 disposés en opposition et symétriquement par rapport à l'axe longitudinal 26 de la ligne hyperfréquence, deux diodes Schottky 80,81 placées chacune entre chaque dipôle et les deux dipôles en opposition étant reliés en série à travers une résistance 83 pour additionner des tensions continues. La sonde dipolaire de tension comporte une option de sortie 85,90 sous pointes (continu) à travers des résistances de protection 82,84.

Comme visible sur les figures 3 et 4, la sonde de courant et la sonde de tension présentent un axe de symétrie confondu avec l'axe longitudinal 26 de la ligne hyperfréquence de façon à capter principalement les champs apparaissant sur les bords de la ligne hyperfréquence et à réjecter au mieux les champs relativement uniformes provenant des rayonnements parasites présents dans le boîtier du circuit hybride à tester.

Par conséquent, le dispositif pour tests hyperfréquences selon l'invention est un transducteur permettant d'utiliser les machines habituelles de tests hyperfréquences. On peut envisager autant de transducteurs que le permet la surface du circuit hybride à tester et le nombre de pointes normalement présentes sur l'équipement de test.

Le dispositif pour tests hyperfréquences, selon l'invention, est particulièrement bien adapté aux mesures dans la gamme des microondes, par exemple de 1 à 100GHz. En effet, la dimension des fonctions hyperfréquences est typiquement de l'ordre du dixième de la langueur d'onde dans le matériau supportant le circuit, soit 0,3mm à 30GHz avec une constante diélectrique de 9, ce qui se prête bien aux possibilités des micromanipulateurs existants.

Bien entendu, l'invention n'est pas limitée à l'exemple de réalisation ci-dessus décrit et on pourra prévoir d'autres variantes sans pour cela sortir du cadre de l'invention. Par exemple, on peut remplacer la ou les diodes Schottky par une diode de modulation (dite diode "PiN") pour effectuer une modulation de l'onde hyperfréquence qui sera détectée en sortie des fonctions hyperfréquences et dont l'amplitude est représentative du champ couplé dans le transducteur.

## Revendications

1. Dispositif de tests hyperfréquences à large bande réalisés in situ pour tester un circuit hyperfréquence qui comprend au moins une ligne hyperfréquence (25) rayonnant une onde électromagnétique, ledit dispositif comprenant un moyen support (20) et des moyens de couplage (15) hyperfréquences portés par ledit moyen support pour capter ladite onde électromagnétique et étant caractérisé en ce que ledit moyen support (20) comprend une première (21) et une seconde (22) faces opposées sensiblement parallèles, ledit moyen support étant placé, lors d'un test, avec sa première face directement en contact avec ladite ligne (25), en ce que lesdits moyens de couplage (15) sont placés sur la seconde face (22) dudit moyen support et en ce que l'épaisseur et le matériau dudit moyen support sont déterminés pour fixer le coefficient de couplage avec ladite ligne hyperfréquence à une valeur assurant un couplage par prélèvement désiré.

2. Dispositif selon la revendication 1, caractérisé en ce que le moyen support est constitué d'une lamelle de silice dont la première face inférieure (21) est transparente et dont la seconde face supérieure (22) est métallisée, les moyens de couplage étant constitués par des gravures sur la face supérieure métallisée de la lamelle de silice.

3. Dispositif selon la revendication 2, caractérisé en ce que les moyens de couplage sont des sondes à boucles de courant pour réaliser un couplage au champ magnétique de l'onde hyperfréquence.

4. Dispositif selon la revendication 2, caractérisé en ce que les moyens de couplage sont des sondes dipolaires de tension pour réaliser un couplage au champ électrique de l'onde hyperfréquence.

5. Dispositif selon la revendication 3, caractérisé en ce que les sondes à boucles de courant sont constituées de deux boucles de courant (50, 51) fonctionnant en tête-bêche et ayant une partie de boucle commune (52), la partie de boucle commune étant coupée pour former deux bornes de connexion (40).

6. Dispositif selon la revendication 5, caractérisé en ce que la ligne hyperfréquence a un axe longitudinal (26) et en ce que les deux boucles de courant (50, 51) sont disposées symétriquement par rapport à l'axe longitudinal de la ligne hyperfréquence, les deux bornes de connexion étant sensiblement alignées sur cet axe longitudinal.

7. Dispositif selon la revendication 6, caractérisé en ce qu'il comporte en outre une diode (45) reliant les deux bornes de connexion (40).

8. Dispositif selon la revendication 4, caractérisé en ce qu'il comporte deux sondes dipolaires de tension (70, 75) disposées en opposition, chaque sonde dipolaire de tension ayant un dipôle équipé d'une diode (80, 81), les dipôles étant en outre reliés en série.

9. Dispositif selon la revendication 8, caractérisé en ce que la ligne hyperfréquence a un axe longitudinal (26) et en ce que les dipoles (70, 75) sont disposés symétriquement par rapport à l'axe longitudinal de la ligne hyperfréquence.

## Patentansprüche

1. Vorrichtung für in situ durchgeführte breitbandige Ultrahochfrequenztests zum Testen einer Ultrahochfrequenzschaltung, die wenigstens eine eine elektromagnetische Welle abstrahlende Ultrahochfrequenzleitung (25) aufweist, wobei die Vorrichtung ein Trägermittel (20) und vom Trägermittel getragene Ultrahochfrequenz-Kopplungsmittel (15) zum Erfassen der elektromagnetischen Welle aufweist und dadurch gekennzeichnet ist, daß das Trägermittel (20) eine erste Seite (21) und eine zweite Seite (22) aufweist, die einander entgegengesetzt und im wesentlichen parallel sind, wobei das Trägermittel bei einem Test mit seiner ersten Seite direkt in Kontakt mit der Leitung (25) gebracht wird, daß die Kopplungsmittel (15) auf der zweiten Seite (22) des Trägermittels angeordnet sind und daß die Dicke und das Material des Trägermittels so bestimmt sind, daß der Kopplungskoeffizient mit der Ultrahochfrequenzleitung auf einen Wert festgelegt ist, der eine gewünschte Abgriffskopplung gewährleistet.

2. Vorrichtung nach Anspruch 1, dadurch gekennzeichnet, daß das Trägermittel durch ein Siliciumdioxidplättchen gebildet ist, dessen untere erste Seite (21) durchlässig ist und dessen obere zweite Seite (22) metallisiert ist, wobei die Kopplungsmittel durch Ätzungen auf der metallisierten Oberseite des Siliciumdioxidplättchens gebildet sind.

3. Vorrichtung nach Anspruch 2, dadurch gekennzeichnet, daß die Kopplungsmittel Stromschleifensonden sind, um eine Kopplung mit dem Magnetfeld der Ultrahochfrequenzwelle zu realisieren.

4. Vorrichtung nach Anspruch 2, dadurch gekennzeichnet, daß die Kopplungsmittel Dipolspannungssonden sind, um eine Kopplung mit dem elektrischen Feld der Ultrahochfrequenzwelle zu realisieren.

5. Vorrichtung nach Anspruch 3, dadurch gekennzeichnet, daß die Stromschleifensonden aus zwei Stromschleifen (50, 51) gebildet sind, die gegensinnig parallel wirken und einen gemeinsamen Schleifenteil (52) haben, wobei der gemeinsame Schleifenteil zur Bildung von zwei Anschlußklemmen (40) unterbrochen ist.

6. Vorrichtung nach Anspruch 5, dadurch gekennzeichnet, daß die Ultrahochfrequenzleitung eine Längsachse (26) hat und daß die beiden Stromschleifen (50, 51) symmetrisch in bezug auf die Längsachse der Ultrahochfrequenzleitung angeordnet sind, wobei die beiden Anschlußklemmen im wesentlichen in einer Linie mit dieser Längsachse liegen.

7. Vorrichtung nach Anspruch 5, dadurch gekennzeichnet, daß sie außerdem eine Diode (45) enthält, welche die beiden Anschlußklemmen (40) verbindet.

8. Vorrichtung nach Anspruch 4, dadurch gekennzeichnet, daß sie zwei Dipolspannungssonden (70, 75) enthält, die einander entgegengesetzt angeordnet sind, wobei jede Dipolspannungssonde einen mit einer Diode (80, 81) ausgestatteten Dipol hat, wobei die Dipole außerdem in Serie geschaltet sind.

9. Vorrichtung nach Anspruch 8, dadurch gekennzeichnet, daß die Ultrahochfrequenzleitung eine Längsachse (26) hat und daß die Dipole (70, 75) symmetrisch in bezug auf die Längsachse der Ultrahochfrequenzleitung angeordnet sind.

## Claims

1. Device for broadband microwave testing carried out in situ in order to test a microwave circuit which comprises at least one microwave line (25) radiating an electromagnetic wave, the said device comprising a support means (20) and microwave coupling means (15) carried by the said support means so as to pick up the said electromagnetic wave, and being characterized in that the said support means (20) comprises a first face (21) and a second face (22) substantially parallel, and opposed, the said support means being placed, during a test, with its first face directly in contact with the said line (25), and in that the said coupling means (15) are placed on the second face (22) of the said support means, and in that the thickness and the material of the said support means are determined to set the coefficient of coupling with the said microwave line at a value providing the desired coupling by pick-up.

2. Device according to Claim 1, characterized in that the support means consists of a wafer of silica, the first lower face (21) of which is transparent and the second upper face (22) of which is metallized, the coupling means consisting of etchings on the metallized upper face of the silica wafer.

3. Device according to Claim 2, characterized in that the coupling means are current-loop probes for causing coupling with the magnetic field of the microwave wave.

4. Device according to Claim 2, characterized in that the coupling means are dipolar voltage probes for causing coupling with the electric field of the microwave wave.

5. Device according to Claim 3, characterized in that the current-loop probes consist of two current loops (50, 51) operating head-to-tail and having a common loop part (52), the common loop part being cut so as to form two connecting terminals (40).

6. Device according to Claim 5, characterized in that the microwave line has a longitudinal axis (26) and in that the two current loops (50, 51) are arranged symmetrically with respect to the longitudinal axis of the microwave line, the two connecting terminals being aligned substantially on this longitudinal axis.

7. Device according to Claim 6, characterized in that it further includes a diode (45) linking the two connecting terminals (40).

8. Device according to Claim 4, characterized in that it includes two dipolar voltage probes (70, 75) arranged in opposition, each dipolar voltage probe having a dipole equipped with a diode (80, 81), the dipoles moreover being linked in series.

9. Device according to Claim 8, characterized in that the microwave line has a longitudinal axis (26) and in that the dipoles (70, 75) are arranged symmetrically with respect to the longitudinal axis of the microwave line.
